# EUROPEAN PATENT SPECIFICATION

(11) **EP 1 592 823 B1**
(45) Date of publication and mention of the grant of the patent: **11.04.2007**
(21) Application number: 03714926.7
(22) Date of filing: 20.02.2003
(51) Int. Cl.: C23C 14/34

(54) **A METHOD OF MANUFACTURING A SPUTTER TARGET**
VERFAHREN ZUR HERSTELLUNG EINES ZERSTÄUBUNGSTARGETS
PROCEDE DE PRODUCTION DE CIBLE DE PULVERISATION

(43) Date of publication of application: 09.11.2005
(73) Proprietor: N.V. BEKAERT S.A., 8550 Zwevegem (BE)
(72) Inventor: VERMEERSCH, Ruben, B-9910 Ursel (BE); TE LINTELO, Johannes, NL-4553 EA Philippine (NL)
(86) International application number: PCT/EP2003/050026
(87) International publication number: WO 2004/074541

(56) References cited:
- WO-A-92/17622
- PATENT ABSTRACTS OF JAPAN vol. 2000, no. 01, 31 January 2000 (2000-01-31) & JP 11 286773 A (YAMAHA CORP;VACUUM METALLURGICAL CO LTD), 19 October 1999 (1999-10-19)
- PATENT ABSTRACTS OF JAPAN vol. 2000, no. 26, 1 July 2002 (2002-07-01) & JP 2001 262326 A (NIKKO MATERIALS CO LTD), 26 September 2001 (2001-09-26)

## Description

### Field of the invention.

The invention relates to a method of manufacturing a sputter target and the resulting sputter target. The coefficient of thermal expansion of the target material is similar to the coefficient of thermal expansion of the target holder.

### Background of the invention.

Sputter targets such as ceramic sputter targets are generally known in the art. They comprise a target material bonded to a target holder.
A preferred method to manufacture flat ceramic sputter targets is by Hot Isostatic Pressing (HIP). Basically, the target manufacturing process comprises three steps :
a) Hot Isostatic Pressing of a ceramic powder (for particular powders, a Cold Isostatic Pressing (CIP) is preferred);
b) machining of the target material into forms ready for bonding;
c) bonding the target material on a target holder (backing plate).

For Hot Isostatic Pressing of the ceramic powder, the ceramic powder is filled in a can. The can with the powder is vacuum degassed to remove any residual gases. Subsequently, the can is welded airtight and put into a HIP oven. A pressure (typically between 500 and 2000 bar) and heating (temperature typically between 250 and 1500 °C) is applied. In this way, a densified ceramic material is obtained. After removing the can material, the densified ceramic material may be further machined. Subsequently, the ceramic material (for example a plate-like structure of the ceramic material) is bonded to the target holder (for example a plate such as a copper plate) with a bonding material as for example indium solder.

This process is suitable to manufacture flat ceramic sputter targets. For rotatable targets (comprising a tubular target holder) on the other hand, the process becomes extremely complicated.

Either for flat as for rotatable sputter targets, it is highly desired to HIP the target material directly onto the target holder, creating in this way a target in one process-step (HIPping and bonding are done in one operation). However, doing so unacceptable high stresses are generated at the interface between the taget material and the target holder due to the difference in the coefficients of thermal expansion of the densified ceramic target material and the target holder.
This can result in a bad adhesion between the target material and the target holder (known as debonding) and the target material will be full of cracks (cracking).

The debonding and cracking is extremely pronounced for targets having a big difference in coefficient of thermal expansion between the target holder and the target material.

Widely differing coefficients of thermal expansion occur for example when the target material comprises a ceramic material whereas the target holder is made from a metal.

### Summary of the invention.

It is an object of the present invention to manufacture a sputter target having low stresses at the interface of the target material and the target holder.

It is another object of the invention to provide a method of manufacturing a sputter target by directly bonding the target material on the target holder by hot isostatic pressing.

It is another object of the invention to provide a sputter target whereby a good match is obtained between the coefficient of thermal expansion of the target material and the target holder.

According to a first aspect of the present invention, a method of manufacturing a sputter target is provided.

The method comprises the steps of :
- providing a target holder having a coefficient of thermal expansion;
- providing a target material having a coefficient of thermal expansion.
   The target mater material comprises at least a first and a second compound. The first compound has a first coefficient of thermal expansion whereas the second compound has a second coefficient of thermal expansion.
   The second coefficient of thermal expansion is higher than the first coefficient of thermal expansion and the second coefficient of thermal expansion is higher than the coefficient of thermal expansion of the target holder;
- bonding said target material to said target holder.

By increasing the concentration of the second compound, the coefficient of thermal expansion of the target material will increase. According to the present invention, the concentration ratio of the first and second compound is chosen so to obtain a good match between the coefficient of thermal expansion of the target material and the coefficient of thermal expansion of the target holder.

Preferably, the difference between the coefficient of thermal expansion of the target material and the target holder is less than 20 %. More preferably, the difference between the coefficient of thermal expansion of the target material and the target holder is less than 10 %, for example less than 5 %.

The first compound comprises preferably a ceramic material such as ceramic powder. Suitable ceramic powders comprise metal oxides such as oxides of zinc (as for example ZnO), oxides of indium (as for example In₂O₃), oxides of copper (as for example Cu₂O and CuO), oxides of gallium (as for example Ga₂O₃), oxides of tin (as for example SnO or SnO₂), oxides of titanium (as for example TiO or TiO₂), oxides of Al (as for example Al₂O₃), indium tin oxides, indium oxides alloyed with tin and mixtures of one or more of these oxides.

The second compound comprises a ceramic material or a metallic material, such as ceramic powder or a metal powder.
Preferably, the second compound comprises a metallic material, for example metal particles such as metal powder particles.
The metallic material comprises preferably zinc, indium, copper, gallium, tin, titanium or aluminium or mixtures of one or more of these metals.

As most metals have a high coefficient of thermal expansion, by increasing the amount of metallic material in the target material, the coefficient of thermal expansion of the target material will be increased. By optimising the concentration of the metallic material in the target material, a match between the coefficient of thermal expansion of the target material and the target holder may be obtained.

Furthermore, the presence of a metallic material in the target material has additional advantages:
In most cases the presence of a metallic material in the target material will improve the bonding of the target material to the target holder.
In addition, the presence of a metallic material in the target material allows it to achieve good densified and solid target structures at relatively low HIP temperatures (lower than 1000 °C). A reduction of the HIP temperature further decreases the risk that debonding and cracking occurs.

In a preferred embodiment the first compound comprises a ceramic material and the second compound comprises a metallic material of the metal of the ceramic material.
As example a target material comprising a ceramic powder as first compound and a metal powder of the metal of the ceramic powder as the second compound can be considered.

Some typical examples are given below :

| | **First compound** | **Second compound** |
|---|---|---|
| Example 1 | Zinc oxide | Zinc |
| Example 2 | Indium oxide | Indium |
| Example 3 | Copper oxide | Copper |
| Example 4 | Gallium oxide | Gallium |
| Example 5 | Tin oxide | Tin |
| Example 6 | Titanium oxide | Titanium |
| Example 7 | Aluminium oxide | Aluminium |
| Example 8 | Indium tin oxide | Indium |
| Example 9 | Indium oxide alloyed with tin | Indium |

The target material may be provided by mixing particles such as powder particles of the first compound and particles such as powder particles of the second compound.
The mixing of the particles may be done by any technique known in the art. A preferred method of mixing the particles is by mechanically alloying.

The term "mechanical alloying" means a process which comprises charging a hermetically sealable container with a mixture of different material powders together with hard balls or rods as a fracturing or milling medium, and milling the charge by tumbling or mechanically agitating the charge until the components attain a super-finely mixed or alloyed state.

The bonding of the target material to the target holder may be obtained by any technique known in the art.
The bonding may for example be obtained by using a solder such as an indium solder. HIPped target material for example may be bonded to the target holder by using a solder such as indium solder.

The method according to the present invention is in particular suitable to manufacture targets whereby the target material is HIPped directly on the target holder in one process-step.
As described above, during the HIP process, the sputter target (target material and target holder) is exposed to high temperatures (temperature typically between 250 and 1500 °C) and pressures (typically between 500 and 2000 bar). This may result in debonding and cracking of the target material. The method of the present invention avoids these drawbacks as the coefficient of thermal expansion of the target material and the coefficient of thermal expansion of the target holder are matched or differ only slightly.

The method according to the present invention may be used to manufacture planar or rotatable targets. The method is in particular very suitable to manufacture rotatable targets.

The method according to the present invention is very useful for the manufacturing of ceramic sputter targets.
Ceramic sputter targets show some very attractive properties. Addition of oxygen during sputtering is limited, easy to regulate and sputtering behavior of the target material is stable.

Sputtering of ceramic layers with metallic targets on the other hand is much more complicated as the oxygen flow must controlled very carefully in order to achieve the good layer-composition. If this oxygen-flow control is not done properly the target is going into 'poisoning mode' which results in very low sputter rates and bad coating properties.

The addition of a certain amount of metal to a ceramic sputter target does not change the stable sputter-conditions compared with the sputter-conditions of a pure ceramic sputter target.
Moreover, due to the presence of a small amount of a metallic material, thermal and electrical conductivity of the target material is improved and power density of the sputter target can be increased. This may result in higher sputter rates.
For the sputter targets according to the present invention, it is preferred that the content of the metallic material is not to high (the content depends on the ceramic material) in order to avoid that the target material will behave as a metallic sputter target.

Furthermore due to the presence of a metallic material into the ceramic target material, the risk that cracks are created in the target material during handling and use of the sputter target, due to the heating during the sputter process, is decreased.
For long tubular sputter targets, and in particular cantilevered ones, stresses are generated due to bending. These stresses can lead to cracks.
The method according to the present invention allows it to manufacture long tubular sputter targets and to manufacture cantilevered ones as the ductility of the target material is increased.

According to a second aspect of the present invention a sputter target obtainable by the above described method is provided.

The sputter target comprises a target material bonded to a target holder; the difference in coefficient of thermal expansion of the target material and the target holder is less than 20 % and more preferably less than 10 %, for example less than 5 %.

The sputter target may comprise a planar target or a rotatable target.

According to a further aspect the invention relates to the use of a target in a sputter process.

### Description of the preferred embodiments of the invention.

A first example of a sputter target according to the present invention comprises an indium tin oxide (ITO) sputter target.
The sputter target is manufactured as follow :
First a can, comprising a backing tube (target holder) and an outer-can is filled with an ISOT-powder (Indium Sesqui Oxide Tin). ISOT powder can be synthesized by mechanically alloying In₂O₃ with Sn particles in a ball-mill. After vacuum-degassing, the can is welded airtight and put into a HIP oven. By applying pressure (typically between 500 and 2000 bar, for example 1000 bar) and heating (temperature typically between 250 and 1500 °C, for example 1000 °C) the ISOT powder is densified.
The coefficient of thermal expansion of the densified ISOT powder is about 6 µm/mK and is much lower than the coefficient of thermal expansion of most metallic target holders. Due to this difference in coefficients of thermal expansion, cracks are formed during the cooling cycle of the HIP operation. After removing the outer-can, one obtains a target material full of cracks without good a good adhesion to the target holder. A sputter target obtained in this way is of no use for sputter applications.

By appropriate mixing of the ISOT powder with Indium particles, showing a high coefficient of thermal expansion (33 µm/mK), the coefficient of thermal expansion of the densified ISOT/In powder after HIP can be matched with the target holder. In this way stresses generated at the interface between the densified ISOT material and the target holder can be limited. This results in a compact densified ISOT structure without cracks.
In table 1 different compositions of target material are given. The content of ISOT and indium particles vary to match with different kind of target holders.
The content of Indium Tin oxide alloyed with Tin (ISOT) and the content of Indium are expressed in volume-percentage. The coefficient of thermal expansion of the target material is given in column 3.

**Table 1**

| ISOT content | Indium content | CTE | Matches with |
|---|---|---|---|
| Vol % | Vol % | [µm/K.m] | |
| 100 | 0 | 6 | |
| 90 | 10 | 8.6 | Titanium |
| 70 | 30 | 13.8 | Ni80Cr20 |
| 60 | 40 | 16.4 | SS AISI 304 |

From table 1 it can be seen that the coefficient of thermal expansion increases with an increasing amount of indium.
With an addition of 10 % indium to ISOT powder a good match is obtained between the target material and a titanium target holder.
With an addition of 30 % indium, a preferred target holder comprises a Ni80Cr20 alloy; whereas with an addition of 40 % indium a preferred target holder comprises stainless steel SS AISI 304.
For a person skilled in the art, it has to be clear that the same principles can be applied for pure ceramic ITO powders mixed with indium.

A second example of a sputter target according to the present invention comprises a ZnO rotatable target. ZnO shows a very tow coefficient of thermal expansion (3 µm/mK). By analogy with the first example, it is not possible to HIP ZnO directly onto a metallic target holder (backing-tube). However, by mixing the ZnO with a metal having a high coefficient of thermal expansion, it becomes possible to match the target material with common target holders in terms of coefficient of thermal expansion.
A suitable metal comprises Zn. Zn shows a coefficient of thermal expansion of 30µm/mK.
The same principles can be applied for making impurity doped ZnO rotatable targets as ZnO:Al or ZnO:Ga. By mixing the ZnO:Al or ZnO:Ga with the appropriate amount of Zn metal particles, a good match between the coefficient of thermal expansion of the target material and the target holder can be obtained.
By applying pressure (typically between 500 and 2000 bar) and heating (temperature typically between 250 and 1500°C) the powder is densified into a compact structure. If a good match has been made with the target holder, good bonding to the target holder can be achieved without cracks in the target material.

The examples above have given a description of how rotatable targets can be made of materials which can be used for sputtering of transparent conductive oxide-layers. The targets show a stable sputter-behaviour without poisoning, as if the target material-was made of pure ceramic material.

## Claims

1. A method of manufacturing a sputter target; said method comprising the steps of :
- providing a target holder having a coefficient of thermal expansion;
- providing a target material having a coefficient of thermal expansion, said target material comprising at least a first and a second compound, said first compound having a first coefficient of thermal expansion, said second compound having a second coefficient of thermal expansion,
whereby said second coefficient of thermal expansion is higher than said first coefficient of thermal expansion and said second coefficient of thermal expansion is higher than said coefficient of thermal expansion of said target holder; the difference in coefficient of thermal expansion of said target holder and of said target material being less than 20%
- bonding said target material to said target holder.

2. A method according to claim 1, whereby said bonding of said target material to said target holder is obtained by hot isostatic pressing (HIPping) said target material directly on said target holder.

3. A method according to claim 1 or 2, whereby the difference between the coefficient of thermal expansion of said target material and the coefficient of thermal expansion of said target holder is less than 10 %.

4. A method according to any one of the preceding claims, whereby said first compound comprises a ceramic material.

5. A method according to claim 4, whereby said ceramic material comprises a ceramic powder.

6. A method according to claim 5, whereby said ceramic powder comprises a metal oxide selected from the group consisting of oxides of zinc, oxides of indium, oxides of copper, oxides of gallium, oxides of tin, oxides of titanium, oxides of aluminium, indium tin oxides, indium oxides alloyed with tin and mixtures of one or more of these oxides.

7. A method according to any one of the preceding claims, whereby said second compound comprises a ceramic material or a metallic material.

8. A method according to claim 7, whereby said ceramic material comprises a ceramic powder.

9. A method according to claim 7, whereby said metallic material comprises metal particles such as metal powder particles.

10. A method according to claim 7 or 9, whereby said metallic material comprises a metal selected from the group consisting of zinc, indium, copper, gallium, tin, titanium or aluminium or mixtures of one or more of these metals.

11. A method according to claim 4, whereby said second compound comprises a metallic material of the metal of said ceramic material of said first compound.

12. A method according to any one of the preceding claims, whereby said target material is provided by mixing particles of said first compound with particles of said second compound

13. A method according to claim 12, whereby said mixing comprises mechanically alloying.

14. A method according to any one of the preceding claims, whereby said sputter target comprises a planar target.

15. A method according to any one of the preceding claims, whereby said sputter target comprises a rotatable target.

16. A sputter target comprising a target material bonded to a target holder, said target being obtainable by a method according to any one of claims 1 to 15.

17. A sputter target according to claim 16, whereby the difference in coefficient of thermal expansion of said target material and said target holder is less than 10 %.

18. A sputter target according to claim 16 or 17, whereby said sputter target comprises a planar target.

19. A sputter target according to claim 16 or 17, whereby said sputter target comprises a rotatable target.

20. The use of a sputter target according to any one of claims 16 to 19 in a sputter process.

## Patentansprüche

1. Verfahren zur Anfertigung eines Sputtertargets, wobei das Verfahren die Schritte umfasst:
- Bereitstellung eines Targethalters, der einen Wärmeausdehnungskoeffizienten aufweist;
- Bereitstellung eines Targetmaterials, welches einen Wärmeausdehnungskoeffizienten aufweist, wobei das Targetmaterial mindestens eine erste und eine zweite Verbindung umfasst, wobei die erste Verbindung einen ersten Wärmeausdehnungskoeffizienten aufweist, die zweite Verbindung einen zweiten Wärmeausdehnungskoeffizienten aufweist,
wobei der zweite Wärmeausdehnungskoeffizient höher als der erste Wärmeausdehnungskoeffizient ist und der zweite Wärmeausdehnungskoeffizient höher als der Wärmeausdehnungskoeffizient des Targethalters ist; wobei der Unterschied des Wärmeausdehnungskoeffizienten des Targethalters und des Targetmaterials weniger als 20 % beträgt;
- Binden des Targetmaterials an den Targethalter.

2. Verfahren nach Anspruch 1, wobei das Binden des Targetmaterials an den Targethalter durch Heißisostatisches Verdichten (HIPen) des Targetmaterials direkt auf den Targethalter erzielt wird.

3. Verfahren nach Anspruch 1 oder 2, wobei der Unterschied zwischen dem Wärmeausdehnungskoeffizienten des Targetmaterials und dem Wärmeausdehnungskoeffizienten des Targethalters weniger als 10 % beträgt.

4. Verfahren nach einem der vorherigen Ansprüche, wobei die erste Verbindung ein keramisches Material umfasst.

5. Verfahren nach Anspruch 4, wobei das keramische Material ein keramisches Pulver umfasst.

6. Verfahren nach Anspruch 5, wobei das keramische Pulver ein Metalloxid umfasst, das ausgewählt ist aus der Gruppe bestehend aus Zinkoxiden, Indiumoxiden, Kupferoxiden, Galliumoxiden, Zinnoxiden, Titanoxiden, Aluminiumoxiden, Indium-Zinnoxiden, Indiumoxiden, die mit Zinn legiert sind sowie Gemischen eines oder mehrerer dieser Oxide.

7. Verfahren nach einem der vorherigen Ansprüche, wobei die zweite Verbindung ein keramisches Material oder ein metallisches Material umfasst.

8. Verfahren nach Anspruch 7, wobei das keramische Material ein keramisches Pulver umfasst.

9. Verfahren nach Anspruch 7, wobei das metallische Material Metallteilchen, wie etwa Metallpulverteilchen umfasst.

10. Verfahren nach Anspruch 7 oder 9, wobei das metallische Material ein Metall umfasst, das ausgewählt ist aus der Gruppe bestehend aus Zink, Indium, Kupfer, Gallium, Zinn, Titan oder Aluminium oder Gemischen eines oder mehrerer dieser Metalle.

11. Verfahren nach Anspruch 4, wobei die zweite Verbindung ein metallisches Material des Metalls des keramischen Materials der ersten Verbindung umfasst.

12. Verfahren nach einem der vorherigen Ansprüche, wobei das Targetmaterial durch Mischen von Teilchen der ersten Verbindung mit Teilchen der zweiten Verbindung bereitgestellt wird.

13. Verfahren nach Anspruch 12, wobei das Mischen mechanisches Legieren umfasst.

14. Verfahren nach einem der vorherigen Ansprüche, wobei das Sputtertarget ein planares Target umfasst.

15. Verfahren nach einem der vorherigen Ansprüche, wobei das Sputtertarget ein rotierbares Target umfasst.

16. Sputtertarget, das ein Targetmaterial umfasst, welches an einen Targethalter gebunden ist, wobei das Target durch ein Verfahren nach einem der Ansprüche 1 bis 15 erhältlich ist.

17. Sputtertarget nach Anspruch 16, wobei der Unterschied zwischen dem Wärmeausdehnungskoeffizienten des Targetmaterials und des Targethalters weniger als 10 % beträgt.

18. Sputtertarget nach Anspruch 16 oder 17, wobei das Sputtertarget ein planares Target umfasst.

19. Sputtertarget nach Anspruch 16 oder 17, wobei das Sputtertarget ein rotierbares Target umfasst.

20. Verwendung eines Sputtertargets nach einem der Ansprüche 16 bis 19 in einem Sputterverfahren.

## Revendications

1. Procédé de fabrication d'une cible de pulvérisation, ledit procédé comprenant les étapes de :
- fourniture d'un porte-cible possédant un coefficient de dilatation thermique ;
- fourniture d'un matériau cible possédant un coefficient de dilatation thermique, ledit matériau cible comprenant au moins un premier et un second composés, ledit premier composé possédant un premier coefficient de dilatation thermique, ledit second composé possédant un second coefficient de dilatation thermique,
par lequel ledit second coefficient de dilatation thermique est supérieur audit premier coefficient de dilatation thermique et ledit second coefficient de dilatation thermique est supérieur audit coefficient de dilatation thermique dudit porte-cible, la différence de coefficient de dilatation thermique entre ledit porte-cible et ledit matériau cible étant inférieure à 20 %;
- collage dudit matériau cible audit porte-cible.

2. Procédé selon la revendication 1, dans lequel ledit collage dudit matériau cible audit porte-cible est obtenu par compression isostatique à chaud (CIC) dudit matériau cible directement sur ledit porte-cible.

3. Procédé selon la revendication 1 ou 2, dans lequel la différence entre le coefficient de dilatation thermique dudit matériau cible et le coefficient de dilatation thermique dudit porte-cible est inférieure à 10 %.

4. Procédé selon l'une quelconque des revendications précédentes, dans lequel ledit premier composé comprend un matériau céramique.

5. Procédé selon la revendication 4, dans lequel ledit matériau céramique comprend une poudre céramique.

6. Procédé selon la revendication 5, dans lequel ladite poudre céramique comprend un oxyde métallique choisi dans le groupe constitué par les oxydes de zinc, les oxydes d'indium, les oxydes de cuivre, les oxydes de gallium, les oxydes d'étain, les oxydes de titane, les oxydes d'aluminium, les oxydes d'indium et d'étain, les oxydes d'indium alliés à de l'étain et les mélanges d'un ou plusieurs de ces oxydes.

7. Procédé selon l'une quelconque des revendications précédentes, dans lequel ledit second composé comprend un matériau céramique ou un matériau métallique.

8. Procédé selon la revendication 7, dans lequel ledit matériau céramique comprend une poudre céramique.

9. Procédé selon la revendication 7, dans lequel ledit matériau métallique comprend des particules métalliques telles que des particules de poudre métallique.

10. Procédé selon la revendication 7 ou 9, dans lequel ledit matériau métallique comprend un métal choisi dans le groupe constitué par le zinc, l'indium, le cuivre, le gallium, l'étain, le titane et l'aluminium, et les mélanges d'un ou plusieurs de ces métaux.

11. Procédé selon la revendication 4, dans lequel ledit second composé comprend un matériau métallique du métal dudit matériau céramique dudit premier composé.

12. Procédé selon l'une quelconque des revendications précédentes, dans lequel ledit matériau cible est fourni en mélangeant des particules dudit premier composé avec des particules dudit second composé.

13. Procédé selon la revendication 12, dans lequel ledit mélange comprend un alliage mécanique.

14. Procédé selon l'une quelconque des revendications précédentes, dans lequel ladite cible de pulvérisation comprend une cible planaire.

15. Procédé selon l'une quelconque des revendications précédentes, dans lequel ladite cible de pulvérisation comprend une cible rotative.

16. Cible de pulvérisation comprenant un matériau cible collé à un porte-cible, ladite cible pouvant être obtenue par un procédé selon l'une quelconque des revendications 1 à 15.

17. Cible de pulvérisation selon la revendication 16, dans laquelle la différence de coefficient de dilatation thermique entre ledit matériau cible et ledit porte-cible est inférieure à 10 %.

18. Cible de pulvérisation selon la revendication 16 ou 17, ladite cible de pulvérisation comprenant une cible planaire.

19. Cible de pulvérisation selon la revendication 16 ou 17, ladite cible de pulvérisation comprenant une cible rotative.

20. Utilisation d'une cible de pulvérisation selon l'une quelconque des revendications 16 à 19 dans un procédé de pulvérisation.
